# EUROPÄISCHE PATENTSCHRIFT

(11) **EP 1 716 586 B1**
(45) Veröffentlichungstag und Bekanntmachung des Hinweises auf die Patenterteilung: **07.03.2012**
(21) Anmeldenummer: 05701621.4
(22) Anmeldetag: 31.01.2005
(51) Int. Cl.: H01L 21/00

(54) **VORRICHTUNG UND VERFAHREN ZUM ÜBERPRÜFEN UND UMDREHEN ELEKTRONISCHER BAUELEMENTE**
DEVICE FOR INSPECTING AND ROTATING ELECTRONIC COMPONENTS
DISPOSITIF ET PROCEDE POUR VERIFIER ET FAIRE TOURNER DES COMPOSANTS ELECTRONIQUES

(30) Priorität: 16.02.2004 DE 102004007703
(43) Veröffentlichungstag der Anmeldung: 02.11.2006
(73) Patentinhaber: Mühlbauer AG, 93426 Roding (DE)
(72) Erfinder: NIKLAS, Sigmund, 93199 Zell-Beucherling (DE); GLAS, Rene, 08228 Rodewisch (DE); BRANDL, Manfred, 93485 Rimbach-Kellersdorf (DE); BRANDL, Franz, 93455 Sattelnpeilstein (DE)
(74) Vertreter: Schmidt, Steffen
(86) Internationale Anmeldenummer: PCT/EP2005/050388
(87) Internationale Veröffentlichungsnummer: WO 2005/078768

(56) Entgegenhaltungen:
- US-A1- 2003 161 711
- US-B1- 6 311 391

## Beschreibung

Die Erfindung betrifft eine Vorrichtung und ein Verfahren zum Überprüfen und Umdrehen elektronischer Bauelemente, insbesondere Flipchips, mit einem an einem Drehpunkt drehbar gelagerten Bauteil zum Umdrehen der elektronischen Bauelemente, wobei an dem Bauteil außenseitig ein erstes Aufnahmeelement zum Aufnehmen eines einzelnen elektronischen Bauelementes von einem Träger und dessen Festhalten während einer Drehbewegung des Bauteils befestigt ist, gemäß den Oberbegriffen der Patentansprüche 1 und 7.

Bei Verfahren, die auf einem Flipchip-Prinzip basieren, werden bekannterweise einzelne in einem Verbund getrennt voneinander angeordnete elektronische Bauteile, wie in einem Wafer angeordnete Halbleiterchips, wobei der Wafer wiederum auf einer dehnbaren Trägerfolie aufgesetzt ist, von dieser Trägerfolie aufgenommen und umgedreht, also auf den Kopf gestellt, um sie in der umgedrehten Lage für das sich anschließende Die-Bond bzw. Die-Sort abzulegen. Hierfür wird der einzelne Chip zunächst von der Rückseite der Trägerfolie her mittels einer Nadel, dem sogenannten Die-Ejector abgelöst und mit einem von der Vorderseite beziehungsweise von oben herangeführten Aufnahmeelement, wie einer Vakuumpipette, übernommen. Die Vakuumpipette ist hierfür in der Regel als Fliptool an einem Fliphead eines um einen Drehpunkt drehbar gelagerten Bauteiles angeordnet und hält den aufgenommenen Chip während einer 180°-Drehung des drehbaren Bauteils fest. Nach der stattgefundenen 180°-Drehung wird der auf diese Weise umgedrehte Chip von einem Pick-and-Place-Element an seiner Rückseite aufgenommen, um den Chip in umgedrehter Lage anschließend zu der gewünschten Position, beispielsweise innerhalb eines Smartcard-Moduls, zu transportieren.

Um die Oberfläche des einzelnen noch auf dem Träger angeordneten Chip vor seiner Aufnahme auf Unversehrtheit zu überprüfen und zugleich eine Prüfung seiner korrekten Lageposition vor dessen Aufnahme durchführen zu können, ist oberhalb des drehbaren Bauteiles eine erste optische Einrichtung, beispielsweise eine Kamera, zur Inspektion des Wafers angeordnet. Da eine senkrecht zur Oberfläche des Wafers und des Chip ausgerichtete optische Verbindungslinie zwischen der ersten optischen Einrichtung und der Waferoberfläche für eine optimierte Überprüfung wichtig ist, ist die Kamera direkt oberhalb des aufzunehmenden Chips angeordnet. Deshalb muss das drehbare Bauteil aus der vertikal verlaufenden optischen Verbindungslinie jedesmal vor der Aufnahme eines Chip herausgedreht werden, um eine sogenannte Waferinspektion durchführen zu können.

Dies hat folgenden sequentiell stattfindenden Verfahrensablauf für jeden Flipchip zur Folge: Zunächst muss eine Überprüfung der Oberfläche des aufzunehmenden Chips mittels der Kamera durchgeführt werden. Anschließend findet ein Hineindrehen des Flipheads in die optische Verbindungslinie statt, um mittels der daran befestigten Vakuumpipette den Chip an seiner oberseitigen Oberfläche aufzunehmen. Nun wird der Chip mittels des drehbaren Bauteils, dessen Drehachse außerhalb der optischen Verbindungslinie angeordnet ist, um 180° derart gedreht, dass sich der Fliphead in einer umgedrehten Lage außerhalb der optischen Verbindungslinie befindet. Eine mittels einer zweiten optischen Einrichtung in Form einer Kamera durchgeführte weitere Überprüfung der Lageposition des Chips soll Daten zu einem Flipoffset des geflippten Chip liefern. Danach wird der geflippte bzw. umgedrehte Chip an eine Ablegeeinrichtung in Form eines Placehead übergeben, und eine Korrektur des Flipoffsets aufgrund übergebener Korrekturwerte durchgeführt.

Ein derartiger Ablauf aufeinanderfolgender Schritte hat einen hohen Zeitaufwand für das gesamte Verfahren zum Überprüfen und Umdrehen eines Chips zur Folge und mindert dadurch den Durchsatz der Vorrichtung. Damit verursacht er auch höhere Betriebskosten.

US 2003/0161711 beschreibt eine Vorrichtung zum Überprüfen und Umdrehen von Bauelementen gemäß dem Stand der Technik.

Demzufolge liegt der vorliegenden Erfindung die Aufgabe zugrunde, eine Vorrichtung und ein Verfahren zum Überprüfen und Umdrehen elektronischer Bauelemente, insbesondere Flipchips, mit einem drehbaren Bauteil zum Umdrehen der Bauelemente zur Verfügung zu stellen, welche zeit- und kostensparend sind.

Diese Aufgabe wird vorrichtungsseitig gemäß den Merkmalen des Patentanspruches 1 und verfahrensseitig gemäß den Merkmalen des Patentanspruches 7 gelöst.

Ein wesentlicher Punkt der Erfindung liegt darin, dass bei einer Vorrichtung zum Überprüfen und Umdrehen elektronischer Bauelemente, wie Flipchips, mit einem an einem Drehpunkt drehbar gelagerten Bauteil zum Umdrehen der elektronischen Bauelemente, an dem außenseitig ein erstes Aufnahmeelement zum Aufnehmen eines einzelnen Bauelements von einem Träger und dessen Festhalten während einer Drehbewegung befestigt ist, ein zweites Aufnahmeelement dem ersten Aufnahmeelement bezüglich dem Drehpunkt gegenüberliegend derart außenseitig am Bauteil angeordnet ist, dass jeweils ein Aufnahmeelement bei jeder Drehung des Bauteils um 180° dem Träger zugewandt ist. Zudem weist das Bauteil zwischen den Aufnahmeelementen eine Durchgangsöffnung derart auf, dass die Durchgangsöffnung bei einer Drehung des drehbaren Bauteils um 90° oder 270° dem Träger zugewandt ist. Auf diese Weise kann während einer 180°-Drehung des drehbaren Bauteiles zunächst der Chip von dem Träger durch das beispielsweise als Vakuumpipette ausgebildete erste Aufnahmeelement aufgenommen werden, nach einer Drehung um die ersten 90° eine optische Verbindungslinie zwischen einer oberhalb des drehbaren Bauteils angeordneten ersten optischen Einrichtung zum Überprüfen der Oberfläche und der korrekten Lageposition eines weiteren auf dem Träger angeordneten Chips aufgrund der vertikal ausgerichteten Durchgangsöffnung und ein Ablegen des mittlerweile umgedrehten Chips nach einer stattgefundenen 180°-Drehung auf einer ebenso oberhalb des drehbaren Bauteils angeordneten und verschiebbaren Ablegeeinrichtung stattfinden. Zugleich wird mittels des zweiten ebenso als Vakuumpipette ausbildbaren Aufnahmeelementes das weitere Bauteil von dem Träger aufgenommen, da mittlerweile das zweite Aufnahmeelement über der Waferoberfläche angeordnet ist. Eine sich anschließende weitere 180°-Drehung in umgekehrter Richtung des drehbaren Bauteiles hat einen erneuten Ablauf des oben beschriebenen Verfahrens zur Folge.

Da innerhalb einer einzigen 180°-Drehung des drehbaren erfindungsgemäß ausgestalteten Bauteils eine Wafer-Inspektion, ein Auf- und Ablegen des Chips sowie dessen Umdrehen und zudem die Aufnahme eines weiteren Chips erfolgen kann, wird hierdurch eine erhebliche Zeitersparnis erreicht. Dies erhöht den Durchsatz der gesamten Vorrichtung erheblich und reduziert somit die Betriebskosten der Vorrichtung.

Gemäß einer bevorzugten Ausführungsform ist das erste Aufnahmeelement an einem ersten Vorsprung und das zweite Aufnahmeelement an einem zweiten Vorsprung des Bauteils befestigt. Die Durchgangsöffnung kann dann zwischen den Vorsprüngen als ein an einer seiner Längsseiten offener Durchgangskanal ausgebildet sein. Dies hat zur Folge, dass nicht nur die Vakuumpipetten in optimierter Weise an dem drehbaren Bauteil befestigbar sind, sondern auch eine einfache Herstellung des Durchgangskanals durch einen Fräsvorgang und somit eine kostengünstige Herstellung möglich ist. Zudem wird durch eine derartige Ausbildung des drehbaren Bauteiles erreicht, dass eine senkrecht zum Verlauf des Durchgangskanals sich erstreckende Drehachse nicht sichthindernd für die erste optische Einrichtung innerhalb des Durchgangskanals angeordnet ist.

Vorzugsweise ist eine zweite optische Einrichtung in Form einer Kamera zur Überprüfung einer korrekten Lage des bereits umgedrehten und gegebenenfalls abgelegten Chips angeordnet, um einen Flipoffset ermitteln zu können und dementsprechend Korrekturdaten an die Ablegeeinrichtung zur Korrektur der Chiplage weitergeben zu können.

Die erste optische Einrichtung wird mit einer vorbestimmbaren Zeitverzögerung nach einem Hineindrehen bzw. Hineinschwenken der Durchgangsöffnung in die optische Verbindungslinie zwischen der ersten optischen Einrichtung und dem zu überprüfenden auf dem Träger angeordneten Chip aktiviert. Auf diese Weise lassen sich bedingt durch die sich mit dem Bauteil drehenden Vorsprünge hervorgerufenen verwischten Bilder zuverlässig vermeiden.

Weitere vorteilhafte Ausführungsformen ergeben sich aus den Unteransprüchen.

Vorteile und Zweckmäßigkeiten sind der nachfolgenden Beschreibung in Verbindung mit der Zeichnung zu entnehmen. Hierbei zeigen:
- Fig. 1: in einer schematischen Vorderansicht eine Vorrichtung zum Überprüfen und Umdrehen von Halbleiterchips gemäß dem Stand der Technik;
- Fig. 2: in einer schematischen Vorderansicht eine Vorrichtung zum Überprüfen und Umdrehen von Halbleiterchips gemäß einer Ausführungsform der vorliegenden Erfindung;
- Fig. 3: in einer perspektivischen Ansicht ein drehbares Bauteil für die Vorrichtung zum Überprüfen und Umdrehen von Halbleiterchips gemäß einer Ausführungsform der Erfindung;
- Fig. 4: in einer schematischen Seitenansicht das in Fig. 3 gezeigte drehbare Bauteil;
- Fig. 5: in einer schematischen Vorderansicht eine Darstellung des Prinzips des erfindungsgemäßen Verfahrens; und
- Fig. 6: in einer schematischen Darstellung Überprüfungsbereiche für eine links- und rechtsherum gedrehte Durchgangsöffnung innerhalb des drehbaren Bauteiles.

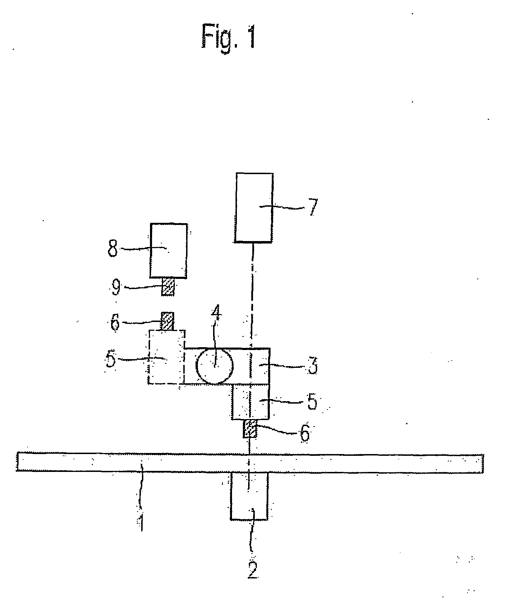

Wie der Fig. 1 in einer schematischen Vorderansicht zu entnehmen ist, ist bisher gemäß dem Stand der Technik für die Ablösung einzelner hier nicht gezeigter Halbleiterchips aus einem Wafer bzw. von dessen Träger 1 mittels einem Die-Ejector 2, ein drehbares Bauteil 3 verwendet worden, welches durch die Ausbildung einer in die Zeichenebene hineinragenden Drehachse für die Ausbildung eines Drehpunktes 4 am linksseitigen Ende des Bauteiles ein Hinein- und Herausschwenken eines Flipheads 5 mit einem daran angeordneten Aufnahmeelement 6 aus einer optischen Verbindungslinie zwischen einer ersten optischen Einrichtung 7 und der Waferoberfläche ermöglicht. Die durchgezogenen Linien des Flipheads stellen eine Aufnahme- bzw. Pick-Position des aufzunehmenden Chips dar, wohingegen die gepunkteten Linien des Flipheads 5 eine sich an den Aufnahmevorgang anschließende Ablegeposition bzw. Place-Position auf einer Ablegeeinrichtung 8 wiedergeben. Die Ablegeeinrichtung 8 weist ebenso ein Aufnahmeelement 9 beispielsweise in Form einer Vakuumpipette auf, um den nun umgedrehten Chip durch Verschieben des Ablegeeinrichtung 8 beispielsweise innerhalb eines Smartcard-Moduls abzulegen.

Ein derartiges drehbares Bauteil weist zum einen nur ein Aufnahmeelement auf und erfordert zum anderen den bereits beschriebenen sequentiellen zeitraubenden Verfahrensablauf.

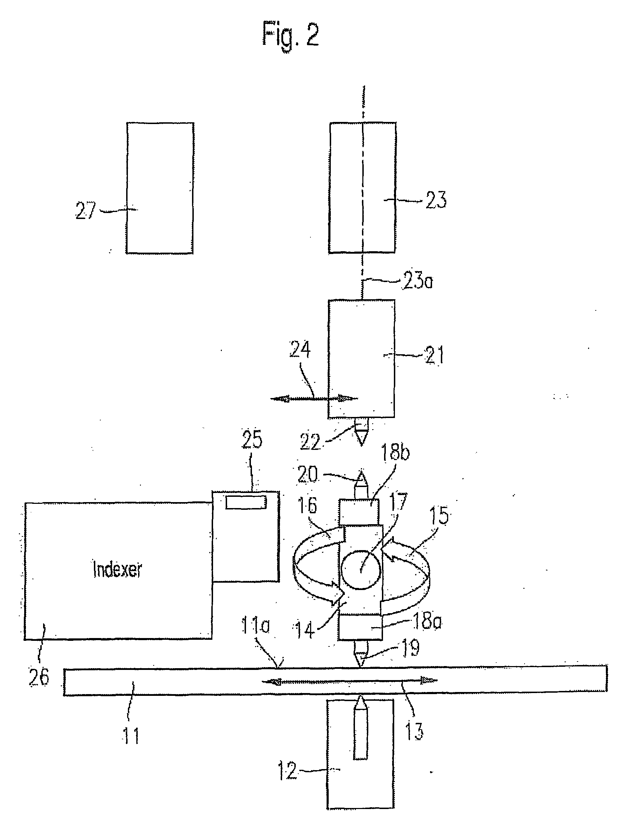

In Fig. 2 ist in einer schematischen Vorderansicht eine Vorrichtung zum Überprüfen und Umdrehen von Halbleiterchips gemäß einer Ausführungsform der Erfindung gezeigt. Dieser Darstellung ist zu entnehmen, dass oberhalb eines Wafers und einen damit verbundenen Trägers 11 mit einer Waferoberfläche 11a, aus dem einzelne Halbleiterchips mittels eines Die-Ejectors 12 von unten nach oben ausgestossen werden, ein drehbares Bauteil 14 derart angeordnet ist, dass es sich bei einer durchgeführten Drehung 15, 16 um einen Drehpunkt 17, der oberhalb des aufzunehmenden Chips angeordnet ist, dreht. Der Wafer kann mit dem Träger 11 in x- bzw. y-Richtung verschoben werden, wie es durch den Doppelpfeil 13 angedeutet wird.

Das drehbare Bauteil 14 weist an backenartigen Vorsprüngen 18a und 18b zwei sich gegenüberliegende Aufnahmeelemente 19, 20 - beispielsweise in Form von Vakuumpipetten - auf, die ein zeitgleiches Auf- und Ablegen von zwei Halbleiter-Chips ermöglichen. Es kann nämlich die erste Vakuumpipette 19 einen Halbleiter-Chip von dem Träger 11 aufnehmen, während die zweite Vakuumpipette 20 einen weiteren Halbleiterchip auf einer Ablegeeinrichtung 21, welche beispielsweise mit einer weitere Vakuumpipette 22 ausgestattet sein kann, ablegt. Anschließend wird die Ablegeeinrichtung 21 seitlich verschoben, wie es durch den Doppelpfeil 24 angedeutet wird.

Nahezu zeitgleich dreht sich das drehbare Bauteil 14 um seinen Drehpunkt 17 - diesmal in entgegengesetzter Richtung zu der vorangegangenen Drehung -, wobei nach einer 90°-Drehung eine in dem drehbaren Bauteil 14 angeordnete hier nicht gezeigte Durchgangsöffnung einen Sichtkanal 23a von einer ersten optischen Einrichtung 23 vertikal verlaufend durch das Bauteil 14 hindurch bis hin zu der Oberfläche 11a des mit dem Wafer bedeckten Trägers 11 zu einem weiteren Halbleiterchip erzeugt.

Dieser Sichtkanal dient dazu, eine Kurzzeit-Aufnahme durch die als Kamera ausgebildete erste optische Einrichtung 23 von dem zukünftig aufzunehmenden weiteren Halbleiter-Chip auf dem Träger 11 für dessen Überprüfung der Oberfläche und seiner korrekten Lageposition durchzuführen.

Sobald das drehbare Bauteil 14 seine 180°-Drehung nach weiteren 90° beendet hat, findet die Aufnahme des weiteren Halbleiterchips durch die zweite Vakuumpipette 20 statt.

Eine zweite optische Einrichtung in Form einer Die-on-Fly-Kamera 25 ist zur Überprüfung eines Flipoffsets des bereits umgedrehten Chips angeordnet. Sie errechnet im Falle des Vorliegens eines Flipoffsets entsprechende Korrekturdaten und gibt diese an das sich einstellbare Place-Element 21 weiter. Das Place-Element 21 legt anschließend des Chip in einem Indexer 26 ab, wobei dessen Lageposition durch eine weitere Kamera 27 überprüft wird.

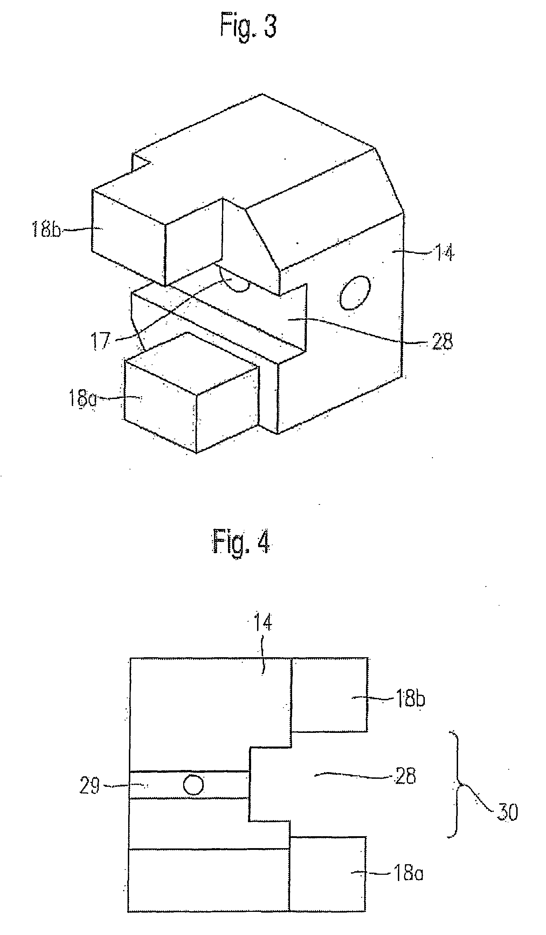

In Fig. 3 ist in einer perspektivischen Ansicht eine mögliche Ausführungsform eines drehbaren Bauteiles 14 für dessen Anordnung in einer erfindungsgemäßen Vorrichtung zum Überprüfen und Umdrehen von elektronischen Bauelementen gezeigt. Wie der Darstellung zu entnehmen ist, ist das drehbare Bauteil mit an seinem Drehpunkt 17 mit einem Loch zur Aufnahme einer hier nicht gezeigten Drehachse, um welche sich das Bauteil 14 dreht, ausgestattet.

Die backenförmig ausgebildeten Vorsprünge 18a und 18b dienen zur Aufnahme und Befestigung von hier nicht gezeigten Aufnahmeelementen, die beispielsweise als Vakuumpipetten ausgebildet sein können.

Die Durchgangsöffnung 28 ist in diesem Fall als an einer Längsseite offener Durchgangskanal, der auf einfache Weise in das Bauteil hineingefräst wurde, ausgebildet.

Wie Fig. 4 in einer Seitenansicht des drehbaren Bauteiles zu entnehmen ist, lässt das Bauteil 14 während seiner Drehung um eine in einem Bohrloch 29 angeordnete Drehachse ein maximales Inspektionsfenster von einem Abstand zwischen den Vorsprüngen 18a und 18b zu. Dieser Abstand kann beispielsweise eine Größenordnung von ca. 20 mm aufweisen. Bei einem Weiterdrehen über die 90°-Stellung des drehbaren Bauteiles 14 hinweg verkleinert sich dann wieder das Inspektionsfenster und verschwindet bei einer 180°-Stellung des drehbaren Bauteils 14 vollständig.

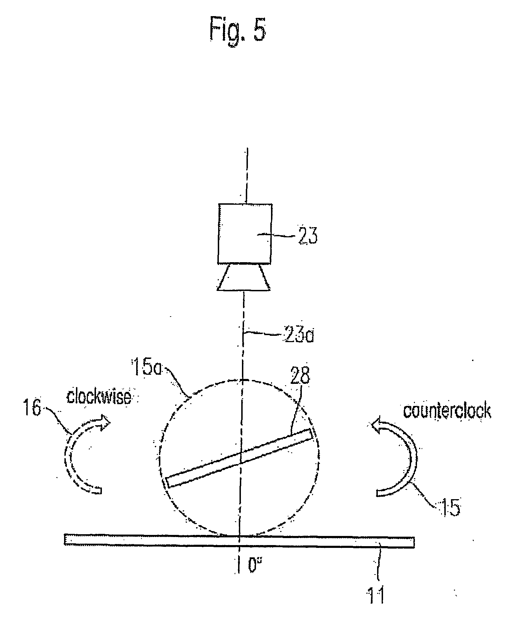

In Fig. 5 wird in einer einfachen schematischen Vorderansicht die Funktionsweise der erfindungsgemäßen Vorrichtung gezeigt. Das hier nicht näher dargestellte drehbare Bauteil, welches zwischen der Kamera 23 und dem Träger 11 angeordnet ist, beinhaltet unter anderem die Durchgangsöffnung 28, welche sich auf einer Kreisbahn 15a bewegt.

Sobald sich die Durchgangsöffnung 28 in vertikaler Stellung befindet, also die hier nicht gezeigten Aufnahmeelemente horizontal ausgerichtet sind, kann die optische Verbindungslinie 23a von der Kamera 23 zu dem zu entnehmenden Halbleiterchip auf dem Träger 11 aufgebaut werden. Innerhalb dieses kurzen Hineinschwenkens der Durchgangsöffnung 28 in die optische Verbindungslinie 23a findet eine Kurzzeitaufnahme der Oberfläche und der Lage des zu entnehmenden Halbleiterchips statt. Ein Weiterdrehen des Bauteiles in eine Richtung entgegen dem Uhrzeigersinn, wie es durch den Pfeil 15 angedeutet wird, lässt das hier nicht gezeigte Aufnahmeelement zu dem zu entnehmenden Chip verschwenken und Aufnehmen. Anschließend findet eine 180°-Drehung des Bauteils in entgegengesetzter Richtung, also im Uhrzeigersinn wie es durch Pfeil 16 gezeigt wird, statt.

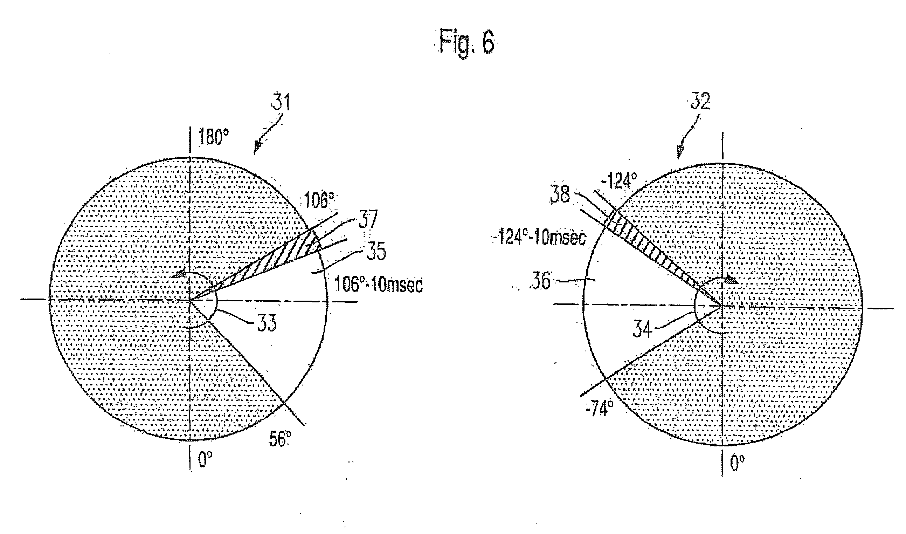

In Fig. 6 werden in einer schematischen Darstellung die Beobachtungs- bzw. Inspektionsbereiche, die der Kamera 23 während einer Drehung des mit der Durchgangsöffnung 28 ausgebildeten Bauteils 14 zur Verfügung stehen, dargestellt. Für eine gesamte 360°-Drehung des Bauteiles und der Durchgangsöffnung entgegen dem Uhrzeigersinn (Bezugszeichen 31) und mit dem Uhrzeigersinn (Bezugszeichen 32), wie es auch durch Pfeile 33 und 34 angedeutet wird, sind zur Verfügung stehende Inspektionsbereiche 35 und 36 bei einer ca. 90°-Stellung des Bauteiles ausgebildet.

Um bei einem Hineinschwenken der Durchgangsöffnung in die optische Verbindungslinie zwischen der Kamera und dem Wafer keine verwischten Bilder zu verursachen, wird die Kamera mit einer Zeitverzögerung von ca. 10 msec, wie es durch Winkelabschnitte 37 und 38 dargestellt wird, aktiviert.

Sämtliche in den Anmeldungsunterlagen offenbarten Merkmale werden als erfindungswesentlich beansprucht, sofern sie einzeln oder in Kombination gegenüber dem Stand der Technik neu sind. Sämtliche in den Anmeldungsunterlagen offenbarten Merkmale werden einzeln und in Kombination als erfindungswesentlich angesehen. Abwandlungen hiervon sind dem Fachmann geläufig.

### Bezugszeichenliste

- 1, 11: Träger
- 2, 12: Die-Ejector
- 3: drehbares Bauteil
- 4, 17: Drehpunkt
- 5: Fliphead
- 6: Aufnahmeelement
- 7,23: Waferoptik-Kamera
- 8: Ablegeeinrichtung
- 9: Aufnahmeelement
- 11 a: Oberfläche des Trägers
- 13: Verschieberichtung des Trägers
- 14: drehbares Bauteil
- 15, 15a, 16: Drehbewegung
- 18a, 18b: erste und zweite Vorsprünge
- 19: erstes Aufnahmeelement
- 20: zweites Aufnahmeelement
- 21: Ablegeeinrichtung
- 22: Vakuumpipette
- 23: Kamera
- 23a: optische Verbindungslinie
- 24: Verschieberichtung des Ablegeeinrichtung es
- 25: Die-on-Fly-Kamera
- 26: Indexer
- 27: Placeoptik-Kamera
- 28: Durchgangskanal
- 29: Bohrloch
- 30: maximales Ausmaß des Inspektionsfensters
- 31,32: Gesamtdrehung des Bauteils
- 33, 34: Drehrichtungen
- 35, 36: Inspektionsbereiche
- 37,38: Winkelabschnitte

## Patentansprüche

1. Vorrichtung zum Überprüfen und Umdrehen elektronischer Bauelemente, insbesondere Flipchips, mit einem an einem Drehpunkt (17) drehbar gelagerten Bauteil (14) zum Umdrehen der elektronischen Bauelemente, wobei an dem Bauteil (14) außenseitig ein erstes Aufnahmeelement (19) zum Aufnehmen eines einzelnen elektronischen Bauelementes von einem Träger (11) und dessen Festhalten während einer Drehbewegung (15, 16; 15a) des Bauteils (14) befestigt ist,
wobei
ein zweites Aufnahmeelement (20) dem ersten Aufnahmeelement (19) bezüglich dem Drehpunkt (17) gegenüberliegend derart außenseitig an dem Bauteil (14) angeordnet ist, dass jeweils ein Aufnahmeelement (19, 20) bei jeder Drehung (15, 16) des Bauteils (14) um 180° dem Träger (11) zugewandt ist, **dadurch gekennzeichnet,**
**dass** in dem Bauteil (14) zwischen den Aufnahmeelementen (19, 20) eine Durchgangsöffnung (28) derart angeordnet ist, dass die Durchgangsöffnung (28) bei einer Drehung (15, 16) des Bauteils (14) um 90° oder 270° dem Träger (11) zugewandt ist.

2. Vorrichtung nach Anspruch 1,
**dadurch gekennzeichnet, dass**
das erste Aufnahmeelement (19) an einem ersten Vorsprung (18a) und das zweite Aufnahmeelement (20) an einem zweiten Vorsprung (18b) des Bauteils (14) befestigt sind.

3. Vorrichtung nach Anspruch 2,
**dadurch gekennzeichnet, dass**
die Durchgangsöffnung (28) zwischen den Vorsprüngen (18a, 18b) als ein an einer Längsseite offener Durchgangskanal (28) ausgebildet ist.

4. Vorrichtung nach einem der vorangegangenen Ansprüche,
**dadurch gekennzeichnet,dass**
auf einer dem Träger (11) abgewandten Seite des drehbaren Bauteils (14) eine erste optische Einrichtung (23) zum optischen Überprüfen von Oberflächen und korrekten Lagepositionen der vor ihrer Aufnahme auf dem Träger (11) angeordneten elektronischen Bauelemente angeordnet ist.

5. Vorrichtung nach Anspruch 4,
**dadurch gekennzeichnet, dass**
die Durchgangsöffnung (28) derart geformt ist, dass sie eine optische Verbindung zwischen der ersten optischen Einrichtung (23) und einem auf dem Träger (11) angeordneten elektronischen Bauelement während einer Drehbewegung (15, 16) des drehbaren Bauteiles (14) zulässt.

6. Vorrichtung nach einem der vorangegangenen Ansprüche,
**gekennzeichnet durch**
eine zweite optische Einrichtung (25) zur Überprüfung einer korrekten Lage des umgedrehten und abgelegten elektronischen Bauelements.

7. Verfahren zum Überprüfen und Umdrehen elektronischer Bauelemente, insbesondere Flipchips, die von einem auf einem Träger (11) angeordneten Verbund elektronischer Bauelemente einzeln mittels eines an einem drehbaren Bauteil (14) angeordneten ersten Aufnahmeelement (19) aufgenommen und in umgedrehter Lage abgelegt werden, wobei das drehbare Bauteil (14) zwischen dem Träger (11) und einer ersten optischen Einrichtung (23) zum Überprüfen der Oberfläche und korrekten Lageposition eines einzelnen auf dem Träger (11) angeordneten Bauelements platzierbar ist, **dadurch gekennzeichnet, dass**
- während einer 180°-Drehung (15, 16) des drehbaren Bauteils (14) eine Aufnahme eines einzelnen auf dem Träger (11) angeordneten elektronischen Bauelements mittels des ersten Aufnahmeelements (19),
eine Überprüfung, wenn das drehbare Bauteil (14) um 90° gedreht ist, einer Oberfläche und korrekten Lageposition eines weiteren aus dem Träger (11) angeordneten elektronischen Bauelements mittels der optischen Einrichtung (23) und einer im drehbaren Bauteil (14) angeordneten Durchgangsöffnung (28),
ein Ablegen des mittels des ersten Aufnahmeelements (19) festgehaltenen elektronischen Bauelements auf einer Ablageeinrichtung (21) nach einer 180°-Drehung (15, 16) des drehbaren Bauteils (14), und
zugleich eine weitere Aufnahme des weiteren einzelnen auf dem Träger (11) angeordneten elektronischen Bauelements mittels einem zweiten gegenüber von dem ersten Aufnahmeelement (19) außenseitig an dem drehbaren Bauteil (14) angeordneten Aufnahmeelements (20) durchgeführt wird.

8. Verfahren nach Anspruch 7,
**dadurch gekennzeichnet, dass**
nach der 180°-Drehung (15) eine in entgegengesetzter Richtung verlaufende 180°-Drehung (16) durchgeführt wird.

9. Verfahren nach Anspruch 7 oder 8,
**dadurch gekennzeichnet, dass**
mittels einer zweiten optischen Einrichtung (25) eine korrekte Lageposition des umgedrehten und abgelegten Bauelements während oder nach seines Transports überprüft und eingestellt wird.

10. Verfahren nach einem der Ansprüche 7 - 9,
**dadurch gekennzeichnet, dass**
die erste optische Einrichtung (23) mit einer vorbestimmbaren Zeitverzögerung (37, 38) nach einem Hineindrehen der Durchgangsöffnung (28) in eine optische Verbindungslinie (23a) zwischen der ersten optischen Einrichtung (23) und dem noch auf dem Träger (11) angeordneten elektronischen Bauelement aktiviert wird.

## Claims

1. Apparatus for examining and turning electronic components, particularly flipchips, with a member (14) rotatably fixed to a pivot point (17) for turning the electronic components, wherein a first pickup element (19) for picking up a single electronic component from a carrier (11) and holding the component during a rotational movement (15, 16; 15a) of the member (14) is attached to an outer side of the member (14),
wherein a second pickup element (20) is opposite the first pickup element (19) relative to the pivot point (17) and is arranged on the outer side of the member (14), such that for each 180°-rotation (15, 16) of the member (14), one of the pickup elements (19, 20) faces the carrier (11), and
**characterized in that** a passageway (28) is arranged in the member (14) between the pickup elements (19, 20) such that the passageway (28) faces the carrier (11) when the member (14) is rotated (15, 16) by 90° or 270°.

2. Apparatus according to claim 1, **characterized in that** the first pickup element (19) is fixed to a first protrusion (18a) of the member (14), and the second pickup element (20) is affixed to a second protrusion (18b) of the member (14).

3. Apparatus according to claim 2, **characterized in that** the passageway (28) between the protrusions (18a, 18b) is designed as a channel (28) which is uncovered along one side of its length.

4. Apparatus according to one of the previous claims, **characterized in that** a first optical device (23) is arranged on a side of the rotatable member (14) opposite the carrier (11) for optically examining surfaces and correct positioning of electronic components arranged on the carrier (11) before they are picked up.

5. Apparatus according to claim 4, **characterized in that** the passageway (28) is formed so as to allow an optical connection between the first optical device (23) and an electronic component arranged on the carrier (11) during a rotation (15, 16) of the rotatable member (14).

6. Apparatus according to one of the previous claims, **characterized by** a second optical device (25) for examining a correct positioning of electronic components that have been turned and released.

7. Method of examining and turning electronic components, particularly flipchips, that are individually picked from a group of electronic components arranged on a carrier (11) by a pickup element (19) arranged on a rotatable member (14) and released upside down, wherein the rotatable member (14) is placable between the carrier (11) and a first optical device (23) for examining the surface and correct positioning of an individual component arranged on the carrier (11),
**characterized in that** in the course of a 180°-rotation (15, 16) of the rotatable member (14), the following steps are executed:
picking up an electronic component arranged individually on the carrier (11) using a first pickup element (19),
examining, when the rotatable member (14) is rotated by 90°, a surface and correct positioning of a further electronic component arranged on the carrier (11) by means of the optical device (23) and a passageway (28) arranged in the rotatable member (14),
depositing the electronic component held by the first pickup element (19) on a deposit device (21) after a 180°-rotation (15, 16) of the rotatable member (14), and
simultaneously picking up a further electronic component arranged individually on the carrier (11) using a second pickup element arranged opposite the first pickup element (19) on an outer side of the rotatable member (14).

8. Method according to claim 7, **characterized in that** after the 180°-rotation (15) a 180°-rotation (16) in the opposite direction is executed.

9. Method according to claim 7 or 8, **characterized in that** during or after transport of a turned and released component, a correct positioning is checked and adjusted by a second optical device (25).

10. Method according to one of claims 7 to 9, **characterized in that** the first optical device (23) is activated after a predeterminable time delay (37, 38) after the passageway (28) is rotated into an optical a connection line (23a) between the first optical device (23) and the electronic component still arranged on the carrier (11).

## Revendications

1. Dispositif pour vérifier et retourner des composants électroniques, notamment des puces retournées appelées en anglais flip chips, comprenant une pièce (14) montée rotative en un point de rotation (17) pour retourner les composants électroniques, dispositif dans lequel un premier élément de prélèvement (19) destiné à prélever un composant électronique individuel à partir d'un support (11) et à le maintenir pendant un mouvement de rotation (15, 16 ; 15a) de la pièce (14) est fixé sur le côté extérieur de ladite pièce (14), et dans lequel un deuxième élément de prélèvement (20) est agencé sur le côté extérieur de la pièce (14), à l'opposé du premier élément de prélèvement (19) par rapport au point de rotation (17), de façon telle que respectivement un élément de prélèvement (19, 20) soit dirigé vers le support (11) à chaque rotation (15, 16) de 180° de la pièce (14),
**caractérisé en ce qu'**une ouverture de passage (28) est agencée dans la pièce (14), entre les éléments de prélèvement (19, 20), de manière telle, que l'ouverture de passage (28) soit dirigée vers le support (11) au cours d'une rotation (15, 16) de la pièce (14) de 90° ou de 270°.

2. Dispositif selon la revendication 1,
**caractérisé en ce que** le premier élément de prélèvement (19) est fixé sur une première protubérance (18a) et le deuxième élément de prélèvement (20) est fixé sur une deuxième protubérance (18b) de la pièce (14).

3. Dispositif selon la revendication 2,
**caractérisé en ce que** l'ouverture de passage (28) est réalisée entre les protubérances (18a, 18b) sous la forme d'un canal de passage (28) ouvert sur un côté longitudinal.

4. Dispositif selon l'une des revendications précédentes,
**caractérisé en ce qu'**un premier ensemble optique (23) est agencé sur un côté de la pièce rotative (14), qui est opposé à celui dirigé vers le support (11), pour la vérification optique de surfaces et de positions d'orientation correctes des composants électroniques agencés sur le support (11) avant leur prélèvement.

5. Dispositif selon la revendication 4,
**caractérisé en ce que** l'ouverture de passage (28) est formée de façon à autoriser une liaison optique entre le premier ensemble optique (23) et un composant électronique agencé sur le support (11), pendant un mouvement de rotation (15, 16) de la pièce rotative (14).

6. Dispositif selon l'une des revendications précédentes,
**caractérisé par** un deuxième ensemble optique (25) destiné à la vérification d'une position correcte du composant électronique retourné et déposé.

7. Procédé pour vérifier et retourner des composants électroniques, notamment des puces retournées appelées en anglais flip chips, qui sont prélevés individuellement à partir d'un ensemble composé de composants électroniques agencé sur un support (11), au moyen d'un premier élément de prélèvement (19) agencé sur une pièce rotative (14), et sont déposés dans une position retournée, la pièce rotative (14) pouvant être placée entre le support (11) et un premier ensemble optique (23) destiné à vérifier la surface et la position d'orientation correcte d'un composant individuel agencé sur le support (11),
**caractérisé en ce que**
pendant une rotation de 180° (15, 16) de la pièce rotative (14), un prélèvement d'un composant électronique individuel agencé sur le support (11) est effectué au moyen du premier élément de prélèvement (19),
une vérification d'une surface et d'une position d'orientation correcte d'un autre composant électronique agencé sur le support (11) est effectuée, lorsque la pièce rotative (14) a tourné de 90°, au moyen de l'ensemble optique (23) et grâce à une ouverture de passage (28) agencée dans la pièce rotative (14),
la dépose du composant électronique maintenu au moyen du premier élément de prélèvement (19) est effectuée sur un emplacement de dépôt (21) après une rotation (15, 16) de 180° de la pièce rotative (14), et
simultanément, un prélèvement supplémentaire dudit autre composant électronique individuel agencé sur le support (11) est effectué au moyen d'un deuxième élément de prélèvement (20) agencé sur le côté extérieur de la pièce rotative (14), à l'opposé du premier élément de prélèvement (19).

8. Procédé selon la revendication 7,
**caractérisé en ce qu'**une rotation (16) de 180° dans le sens opposé est effectuée après la rotation (15) de 180°.

9. Procédé selon la revendication 7 ou la revendication 8,
**caractérisé en ce qu'**une position d'orientation correcte du composant retourné et déposé est vérifiée et réglée, pendant ou après son transport, au moyen d'un deuxième ensemble optique (25).

10. Procédé selon l'une des revendications 7 à 9,
**caractérisé en ce que** le premier ensemble optique (19) est activé avec un retard prédéterminé (37, 38) après avoir amené, par rotation, l'ouverture de passage (28) sur une ligne de liaison optique (23a) entre le premier ensemble optique (23) et le composant électronique encore agencé sur le support (11).
